Europäisches Patentamt

**European Patent Office**

**Office européen des brevets ·**

(19)

(11) Publication number:

**0 250 007**

**A2**

(12)

# EUROPEAN PATENT APPLICATION

(21) Application number: **87200416.3**

(22) Date of filing: **06.03.87**

(51) Int. Cl.⁴: **H03K 19/088** , H03K 19/013

(30) Priority: **19.06.86 US 876037**

(43) Date of publication of application:
**23.12.87 Bulletin 87/52**

(84) Designated Contracting States:
**DE FR GB NL**

(71) Applicant: **Monolithic Memories, Inc.**
**2175 Mission College Blvd.**
**Santa Clara, CA 95050(US)**

(72) Inventor: **Tavana, Danash M.**
**770 Opal Drive**
**San José California 95112(US)**
Inventor: **Wong, Sing Y.**
**679 Timberpine Avenue**
**Sunnyvale California 94086(US)**

(74) Representative: **Noz, Franciscus Xaverius, Ir.**
**et al**
**Algemeen Octrooibureau P.O. Box 645**
**NL-5600 AP Eindhoven(NL)**

(54) **TTL Buffer circuit.**

(57) A TTL buffer circuit (30) which is switched by increasing or decreasing voltage input signals Ii at the same threshold, and which switches at increased speed. A bleed transistor Q6 allows the phase splitter transistor (Q3) base to begin charging before the bleed transistor Q6 turns on. While the phase splitter transistor (Q3) is on, the bleed transistor current is limited to avoid interfering with operation of the phase splitter transistor. When the phase splitter control lead (34) current is cut off, the phase splitter (Q3) base capacitance is discharged rapidly through the bleed transistor (Q6), at the end of which the phase splitter and bleed transistors stop conducting.

FIG. 3

## TTL BUFFER CIRCUIT

### Background of the Invention

This invention relates to electronic circuits and, more specifically, to a buffer circuit which switches on and off at high speed and at the same voltage threshold of increasing and decreasing input signals.

Logic circuits commonly exchange signals through input and/or output buffers to avoid overpowering circuit input terminals, to increase circuit output signal power, or to block signal noise from entering or exiting, and interfering with the proper operation of, the circuit.

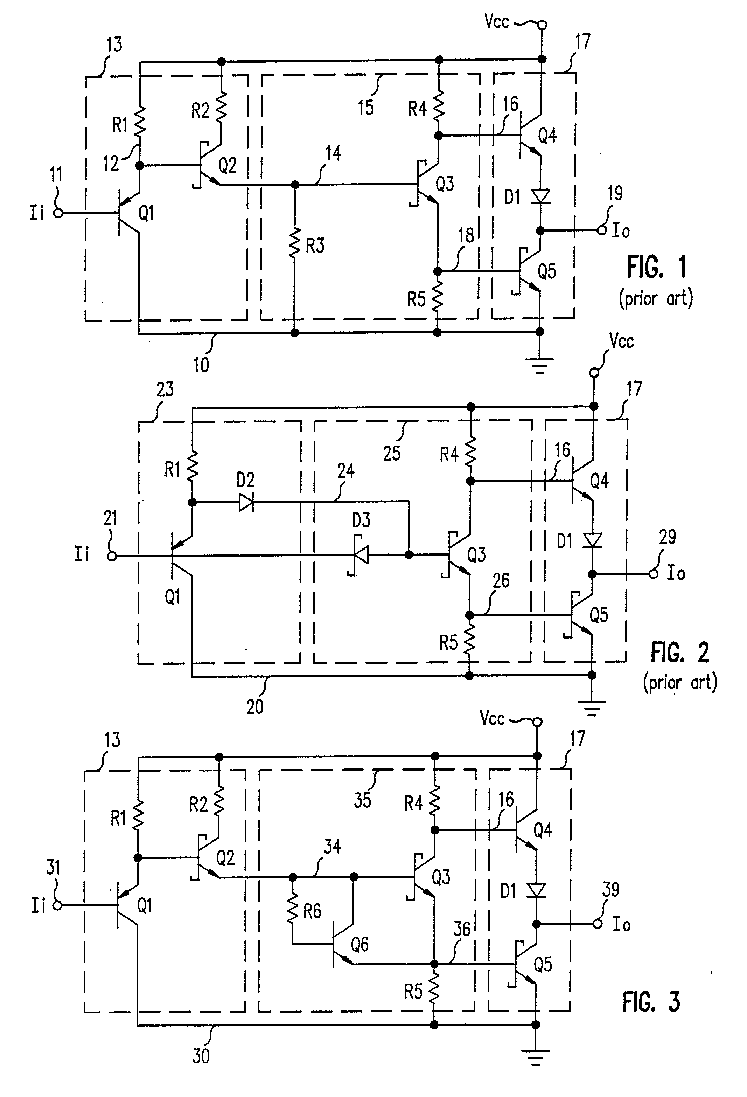

A prior art transistor transistor logic (TTL) inverting buffer circuit 10 as shown in Fig. 1 includes an input stage 13, a phase splitter stage 15, and an output stage 17.

An alternating high and low voltage input signal Ii received at input terminal 11 causes input stage 13 to produce, on lead 14, a phase splitter control signal, which is in phase with input signal Ii. The phase splitter control signal causes stage 15 to produce, on line 18, a current sink control signal in phase with signal Ii, and simultaneously to produce, on line 16, a current source control signal, opposite in phase from signal Ii. Output stage 17 either, when input signal Ii is low, receives a high source control signal on line 16 which turns on current source transistor Q4 to source current Io to output terminal 19, or when input signal Ii is high, receives a high sink control signal on line 18, which turns on current sink transistor Q5 to sink current Io from output terminal 19. Thus, output signal Io is of opposite phase (i.e., inverted) from input signal Ii.

An output signal Io opposite in phase from input signal Ii is provided by output stage 17 switching when the phase splitter control voltage on lead 14 crosses a threshold of 2Vbe, because when the lead 14 voltage is below 2Vbe, the lead 18 voltage, which is 1Vbe drop lower, keeps current sink transistor Q5 off. While the lead 14 voltage is below 2Vbe, phase splitter transistor Q3 conducts little or no current through resistor R4, so that transistor Q3 does not lower the source control voltage on lead 16 below the high output threshold of current source transistor Q4, which allows source transistor Q4 to conduct current to terminal 19.

Conversely, when the phase splitter control voltage on line 14 rises to a threshold of 2Vbe, phase splitter transistor Q3 provides a high (1Vbe) sink control signal of lead 18 which turns on current sink transistor Q5, thereby sinking current Io from terminal 19, while the transistor Q3 collector current through resistor R4 lowers the voltage of lead 16 and turns off current source transistor Q4.

Input circuit 13 provides a high (2Vbe) phase splitter control signal on lead 14 when input signal Ii exceeds a threshold voltage which is also equal to 2Vbe, because the node 12 voltage follows 1Vbe above the voltage of signal Ii, and transistor Q1 conducts only until signal Ii rises to 2Vbe and raises the node 12 voltage to 3Vbe, in which event transistors Q2, Q3, and Q5 all conduct, and prevent the node 12 voltage from rising higher. An input signal Ii voltage exceeding 2Vbe leaves a voltage drop of less than 1Vbe between base lead 11 and emitter lead 12 of transistor Q1, which turns off input transistor Q1.

Conversely, when input signal Ii falls below 2Vbe, the base-emitter junction of transistor Q1 becomes forward biased, transistor Q1 turns on, the node 12 voltage falls below 3Vbe, and transistor Q2 turns off and no longer provides a phase splitter control voltage of 2Vbe on line 14. Thus, the phase splitter control voltage on lead 14 follows the input signal Ii voltage on terminal 11 across a threshold of 2Vbe.

When input signal Ii switches to a low voltage, input stage 13 cuts off current to phase splitter control lead 14, but the phase splitter transistor Q3 base capacitance remains charged, and must be discharged for transistor Q3 to switch completely off. It is important to switch transistor Q3 rapidly so that, in turn, output transistors Q4 and Q5 will be switched rapidly and produce a steep and distinct transition (rise) in the voltage level of output signal Io. The relatively slow discharge of the base of transistor Q3 through its emitter is assisted in circuit 10 by a bleed resistor R3 connected from lead 14 to ground. The lower its resistance value, the more current resistor R3 diverts from the base of phase splitter transistor Q3, which speeds the turn off of phase splitter transistor Q3, but undesirably slows the turn on of phase splitter transistor Q3. Furthermore, the drive current supplied to phase splitter input lead 14 is partially bled through resistor R3 to ground and thus wasted.

In the prior art circuit 20 of Fig. 2, the phase splitter control signal switching threshold voltage on line 24 is again 2Vbe. A Schottky diode D3 is connected at its anode to the base of phase splitter transistor Q3 and connected at its cathode to input terminal 21. Diode D3 is reverse biased and does not conduct while the input signal Ii voltage on terminal 21 is equal to the voltage on lead 24. The switching threshold voltage for a falling input signal

li in circuit 20 is 2Vbe-Vsch (where Vsch is the threshold voltage of Schottky diode D3). At this threshold diode D3 turns on and bleeds current from the base of phase splitter transistor Q3 faster than would a resistor such as R3 in circuit 10 of Fig. 1. However, in switching input signal li from above to below 2Vbe, there is a "dead band" from 2Vbe down to 2Vbe-Vsch, where lead 24 remains charged at a constant voltage, and the base of phase splitter transistor Q3 floats. Thus, circuit 20 does not switch on and off at equal input signal li voltage thresholds. Unequal threshold voltages are unsatisfactory for many applications of buffers, especially under varying temperature conditions, which can influence the difference between threshold levels.

There remains a need, therefore, for a TTL buffer circuit which switches rapidly at equal on and off threshold voltages.

## SUMMARY

The present invention achieves these and other objects by providing a buffer circuit including a phase splitter stage with a bleed transistor having emitter and collector leads connected between ground and the base of the phase splitter transistor, and having a base lead connected through a resistor to the phase splitter base. Charge sufficient to turn on the phase splitter transistor also turns on the bleed transistor, which conducts a discharge current to ground. The phase splitter is turned off rapidly when the buffer input signal voltage falls below the same threshold at which the phase splitter is turned on by a rising signal. Discharge current through the bleed transistor is limited, preferably by a resistor in the base lead of the bleed transistor, to leave sufficient base current to control the phase splitter transistor.

## BRIEF DESCRIPTION OF THE DRAWING

Fig. 1 is a schematic of a prior art TTL buffer circuit with equal input signal thresholds for switching on and off, but relatively slowly;

Fig. 2 is a schematic of a prior art TTL buffer circuit which switches faster than the circuit of Fig. 1 but which switches off at a threshold Vsch lower than the threshold for switching on;

Fig. 3 is a schematic of of a TTL buffer circuit according to the present invention in a preferred embodiment which switches faster than the prior art circuits of Figs. 1 and 2, and has equal on and off thresholds; and

Fig. 4 is a schematic of an alternate embodiment of a TTL buffer according to the invention showing how the buffer can use multiple input stages to perform logic operations.

## DETAILED DESCRIPTION

The present invention is a TTL buffer, shown in a preferred embodiment as circuit 30 in Fig. 3. Circuit 30 includes an input stage 13, a phase splitter stage 35, and an output stage 17, which operate between a positive power supply Vcc and a negative potential Gnd to receive an input signal li and to produce an output signal lo opposite in phase from input signal li.

Input stage 13 and output stage 17 of circuit 30, Fig. 3, operate identically to like-numbered stages of prior art circuit 10 of Fig. 1, as described above. Other input circuits could be used in place of input stage 13. For example, if input lead 31 is otherwise protected from out-of-range voltages and currents in signal li, then resistor R1 and transistor Q1 could be omitted, and input lead 31 connected directly to the base of transistor Q2.

In accordance with the teachings of this invention, a bleed transistor Q6 is provided to bleed charge from the base of, and facilitate turning off, phase splitter transistor Q3. A resistor R6 is also provided between phase splitter input lead 34 and the base of transistor Q6 to supply current for charging the base of transistor Q6. However, bleed transistor Q6 does not draw current through resistor R6 until node 34 has charged to about 1 Vbe, which allows the node 34 voltage to rise to 2Vbe faster, and thus allows phase splitter transistor Q3 to turn on faster, than in prior art circuit 10. Bleed transistor Q6 should conduct only a small current, to limit the current diverted from the base of Q3.

When transistor Q2 turns off, the charge remaining in the base of phase splitter transistor Q3 causes transistor Q6 to bleed charge from lead 34 through the collector and out the emitter of transistor Q6 to ground, without the need (as in prior art circuit 20) of reducing the input signal li voltage below 2Vbe. Discharge current of the base of phase splitter transistor Q3 through the collector of Q6 is greater than through resistor R6 by a factor equal to the beta of transistor Q6. Bleed transistor Q6 stays on until the charge on its base and on lead 34 is discharged to just below the threshold of phase splitter transistor Q3, through the emitter of Q3 and through the emitter of Q6, to lead 36.

Although transistor Q6 bleeds charge from lead 34 while the phase control signal on line 34 is high, the prior art (Fig. 1) waste of this current is avoided in the preferred embodiment by connecting the emitter of bleed transistor Q6 to sink control lead 36.

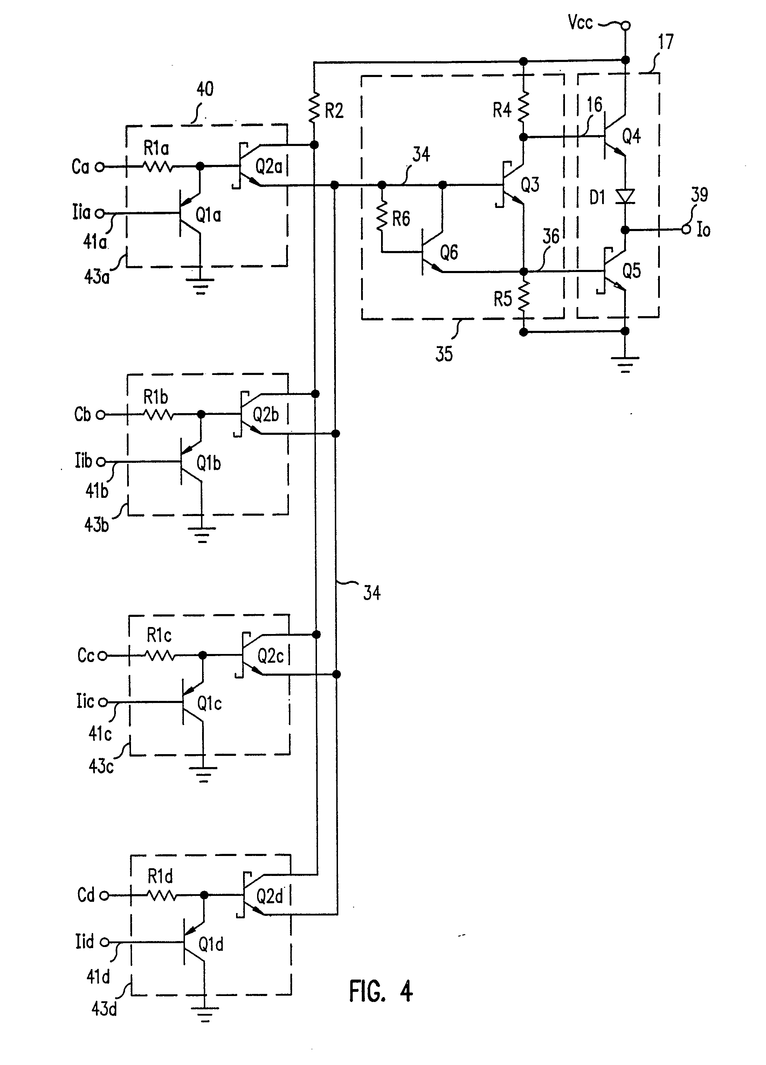

The characteristic that, unlike prior art circuit 20, in circuit 30 the base of phase splitter transistor Q3 is not discharged through a connection to input terminal 31 and a falling input signal Ii, allows logic operations to be performed in the input stage. Referring to Fig. 4, multiple input stages 43a, 43b, 43c, 43d, etc., with respective input terminals 41a, 41b, 41c, 41d, can be connected, in place of input stage 13 of Fig. 3, between resistor R2 and phase splitter control lead 34. For example, a wired OR gate is formed by multiple input circuits 43, with respective control signal inputs Ca, Cb, Cc, and Cd all connected to Vcc. Any one or more of input signals Iia, Iib, Iic, or Iid being high causes the corresponding input stage 43 to turn on phase splitter transistor Q3, producing a low input signal Io, while other input circuits 43 with low input signals Ii will not bleed charge from lead 34 and the base of phase splitter transistor Q3.

Alternately, circuit 40 can be used as a multiplexer by connecting control leads Ca, Cb, Ce, and Cd to selection control circuits (not shown) and selecting input signals at terminals Iia, Iib, Iic, Iid, etc.

The present invention has been described in a preferred embodiment, of which modifications and adaptations within the scope of the invention will occur to those skilled in the art. The invention is limited only by the following claims.

## Claims

1. A TTL buffer circuit of the type operating between a voltage supply and ground and wherein an output stage is controlled by a phase splitter stage, and the phase splitter stage is in turn controlled through a phase splitter control lead by a signal provided by an input stage, characterized in that the phase splitter stage comprises:
a phase splitter transistor having a base lead connected to the control lead and having first and second current leads; and
a bleed transistor having a base lead coupled to the control lead, and having first and second current leads, a first of which is connected to the control lead, and the second of which is connected to the second current lead of the phase splitter transistor and coupled to ground.

2. A circuit as in Claim 1 characterized in that: the bleed transistor base lead is coupled through a first resistor to the control lead.

3. A circuit as in Claim 1 characterized in that: said second current leads are connected to ground through a second resistor.

4. A circuit as in Claim 1 characterized in that said second current leads of the bleed transistor and of the phase splitter transistor are emitter leads.

5. A circuit as in Claim 4 characterized in that: said transistors are NPN transistors.

6. A circuit as in Claim 5 characterized in that: said phase splitter transistor is a Schottky transistor.

FIG. 1
(prior art)

FIG. 2
(prior art)

FIG. 3

FIG. 4